Europäisches Patentamt

European Patent Office

Office européen des brevets

Publication number: **0 290 182**
**A1**

## EUROPEAN PATENT APPLICATION

Application number: **88303737.6**

Date of filing: **26.04.88**

Int. Cl.⁴: **G01R 1/067**

Priority: **06.05.87 US 47845**

Date of publication of application:
**09.11.88 Bulletin 88/45**

Designated Contracting States:
**DE FR GB**

Applicant: **Hewlett-Packard Company**
**3000 Hanover Street**
**Palo Alto California 94304(US)**

Inventor: **McTigue, Michael T.**
**1252 Hofstead Terrace**
**Colorado Springs Colorado 80907(US)**
Inventor: **Rush, Kenneth**
**7001 Oak Valley Drive**
**Colorado Springs Colorado 80919(US)**

Representative: **Colgan, Stephen James et al**
**CARPMAELS & RANSFORD 43 Bloomsbury**
**Square**
**London WC1A 2RA.(GB)**

**High frequency passive probe.**

A passive electronic probe using a distributed resistance (80) and having low capacitance suitable for high frequency work in conjunction with digital oscilloscopes, logic analyzers, or similar measuring instruments is disclosed.

FIG 2

## High Frequency Passive Probe

### Background of the Invention

The present invention relates to electrical probing, and more specifically to probing in digital oscilloscopes, logic analyzers, or other measuring systems where an electrical circuit is probed at a point remote from the measuring instrument.

Two major requirements for probing systems are that the response at the instrument is an accurate replication of the signal of the system under test, and that the integrity of the signal of the system under test is not significantly impaired.

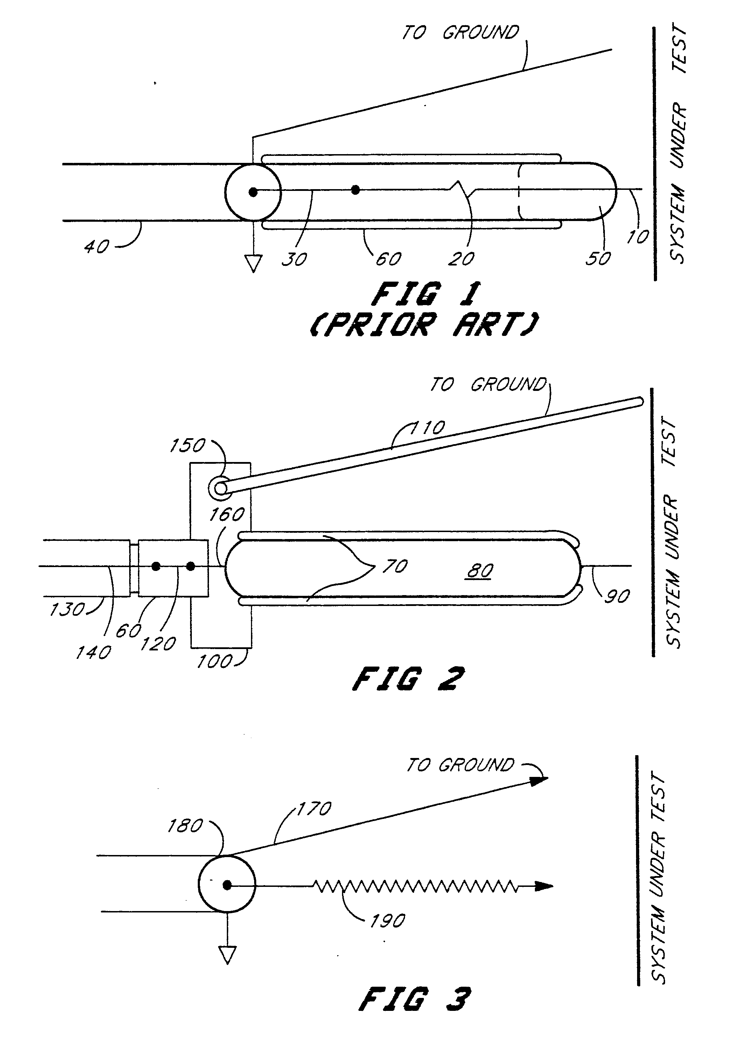

Probes used in the prior art for probing high frequency low impedance circuits (generally greater than 500 MHz, less than 500 ohms) were designed to meet these requirements by minimizing load capacitance and maximizing bandwidth while maintaining an acceptable resistive load. One well known type of design for these probes was to use a coaxial structure as shown in Figure 1. The probe consisted of a metal tip structure 10 attached to a lumped resistance 20 in series with the center conductor 30 of an attached standard coaxial cable 40, surrounded at the tip by a dielectric 50 and enclosed in a conductive casing 60. Probes built using this type of design could typically achieve load capacitance less than or equal to 2 pF. and bandwidth less than or equal to 1 GHz.

### Summary of the Invention

In accordance with the illustrated preferred embodiment of the present invention, a passive probe is designed using a parallel wire high impedance transmission line in which the wire connecting the center conductor of a standard coaxial cable to the system under test is implemented as a distributed resistance supported by a nonconducting structure and the other wire connecting the ground of the coaxial cable to the ground of the system under test is implemented as a standard conductor. The distributed resistance has very low end-to-end capacitance and the nonconducting nature of the supporting structure adds only insignificant capacitive loading to the probe. The result is a passive probe design which can achieve load capacitance of approximately 250 fF. and a frequency response which decreases less than 3 dB. from the zero frequency response at frequencies up to at least 6 GHz.

### Brief Description of the Drawings

Figure 1 shows an example of a passive probe design for high frequency probes which is well known in the prior art.

Figure 2 depicts a probe according to the preferred embodiment of the present invention.

Figure 3 is a schematic of a probe according to the preferred embodiment of the present invention.

### Detailed Description of the Preferred Embodiment

Figure 2 shows a drawing of one embodiment of the present invention. Resistor lead 90 is used to contact the system under test and pin 110 is used to contact the ground of the system under test. Resistor lead 90 is connected to the distributed resistor 80. Resistor lead 160, which is connected to the opposite side of resistor 80, is connected to the center conductor 120 of coaxial connector 60 which in turn is connected to the center conductor 140 of a coaxial cable 130. The resistor 80 is supported by the nonconducting structure 70 which is attached to the conducting support base 100. The nonconducting structure 70 may be built from any of a number of materials which are durable and which have a negligible effect on the capacitance of the probe tip. Materials with a dielectric constant below 12 to 15 would work, for example, polytetraflouroethylene (sold under the trade name Teflon), Nylon, Delrin (sold by DuPont), porcelain, or glass. The conducting support base 100 is attached to the outer or ground conductor of the coaxial cable 130. In this embodiment, pin 110 is connected to the conducting support base 100 at the pivot point 150. The pivot allows some flexibility in the placement of the pin on the system under test. In this embodiment, the connection of pin 110 to base 100 permits separation of pin 110 from resistor lead 90 which tends to avoid additional capacitance.

The distributed resistance in the parallel wire transmission line structure is large enough to damp out the reflections that occur due to nontermination of the line in its characteristic impedance but not large enough to lower the corner frequency formed by the total resistance and the end-to-end capacitance of the resistor to the point where the performance of the probe is impaired. This balance is achieved by selecting the proper length of the resistor versus its value in ohms.

Once the attenuation of the probe is established by the designer, the required resistance for the distributed resistor is known. For example, a 10:1 probe using 50 ohm transmission lines requires a 450 ohm resistor in the probe tip for the correct voltage division. A long resistor is then chosen which meets this specification and has a low end-to-end capacitance. The resistor-capacitor time constant formed by the distributed resistance and the end-to-end capacitance controls the bandwidth. The 450 ohm resistor used for one embodiment was part number MD0681, model number MG680, acquired from Caddock Electronics, Inc. in Riverside, CA.

In the prior art design shown in Figure 1, significant capacitance is created between the tip 10 and the casing 60 through the dielectric 50. Since the resistor 80 in Figure 2 is supported by a nonconducting structure 70, the amount of capacitance created is not significant in comparison with other sources of capacitance. Other sources include the end-to-end capacitance of the distributed resistor which is extremely small, and the capacitance created between the tip 90 and the system under test, which cannot be removed.

Figure 3 shows a generalized schematic of a preferred embodiment of the invention. A distributed resistor 190 is connected to a center conductor of transmission line 180 while a conductor 170 is connected to an outer conductor of transmission line 180. Using this general design with a 450 ohm distributed resistor with a standard 50 ohm transmission line, a 10:1 probe was realized having 250 fF. of capacitance and 500 ohms of resistance. The resistor used was approximately 0.75 inches long. Using this design with a 950 ohm distributed resistor and a standard 50 ohm transmission line, a 20:1 probe was realized having 250 fF. of capacitance and 1000 ohms of resistance. The resistor used was approximately 1.0 inches long.

means (80) at a point where the resistor means (80) is connectable to the transmission lines for acquiring a reference to the signal from the system under test.

## Claims

1. A passive electronic probe for use in digital oscilloscopes or similar measuring instruments, comprising:

resistor means (80) having a distributed resistance connectable to standard transmission lines and connectable to a system under test for acquiring a signal from the system under test, and

support means (70) attached to resistor means having a nonconducting nature for mechanically supporting the resistor means.

2. A probe as claimed in claim 1, further comprising:

conductor means (110) connectable to the system under test attached pivotedly to the resistor

0 290 182

TO GROUND

SYSTEM UNDER TEST

40

30 60 20 50 10

FIG 1
(PRIOR ART)

TO GROUND

150

160

110

70

80

90

SYSTEM UNDER TEST

130 60 120
140 100

FIG 2

TO GROUND

180

170

190

SYSTEM UNDER TEST

FIG 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-B-1 171 518 (TELEFUNKEN)<br>* Column 2, lines 38-50 * | 1 | G 01 R 1/067 |
| Y | | 2 | |
| | --- | | |
| Y | IBM TECHNICAL DISCLOSURE BULLETIN, vol. 8, no. 4, September 1965, page 525, New York, US; R.T. ADSMOND et al.: "Continuity tester"<br>* Whole article * | 2 | |
| | --- | | |
| A | GB-A- 683 034 (ELECTRICAL & AUTO PRODUCTS)<br>----- | | |

TECHNICAL FIELDS
SEARCHED (Int. Cl.4)

G 01 R

The present search report has been drawn up for all claims

| Place of search | Date of completion of the search | Examiner |
|---|---|---|
| THE HAGUE | 09-08-1988 | HOORNAERT W. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P0401)